# EUROPEAN PATENT APPLICATION

(11) **EP 1 361 480 A1**
(43) Date of publication of application: **12.11.2003**
(21) Application number: 03252827.5
(22) Date of filing: 06.05.2003
(51) Int. Cl.: G03F 7/32

(54) **Residue reducing stable concentrate**

(30) Priority: 07.05.2002 US 378308 P
(71) Applicant: Shipley Co. L.L.C., Marlborough, MA 01752 (US)
(72) Inventor: Lundy, Daniel E., Winchendon, Massachusetts 01475 (US); Barr, Robert K., Shrewsbury, Massachusetts 01545 (US); Anzures, Edgardo, Westborough, Massachusetts 01581 (US)
(74) Representative: Kent, Venetia Katherine

(57) **Abstract**

A stable concentrate and method to reduce or prevent residue and scum formation on a substrate. The stable concentrate has an alkaline component in combination with another compound in a sufficient amount to reduce or prevent the formation of residue and scum on a substrate. The stable concentrate may be employed in developing processes in the manufacturing of printed wiring boards.

## Description

### Background of the Invention

The present invention is directed to a concentrate for reducing or preventing formation of residue and scum. More specifically, the present invention is directed to a stable concentrate containing an alkaline component and a component for reducing or preventing the formation of residue and scum.

Contaminants such as built-up organic residue and scum from photolithographic compositions present difficult cleaning problems for the electronics industry. Photolithographic residue and scum such as from photoresist can build-up on various products and apparatus. Photoresist materials are employed in the manufacturing of semiconductor devices, and electronic components such as integrated circuits, photomasks for the manufacturing of integrated circuits, printed wiring boards and the like as well as planographic printing plates. In photolithographic processing, a substrate surface is coated with a photoresist, to provide a layer that is sensitive to actinic radiation which is irradiated pattern-wise with the actinic radiation. The irradiated photoresist is then developed with a developer solution to form a patterned photoresist layer that serves to selectively protect the substrate surface from etching, plating or diffusion of dopants.

Photoresists may be positive-working, or negative-working. Such photoresists may be liquid, or dry film. A photoresist composition of the positive-working type has such a photosensitivity that solubility of the composition in the developer solution is increased by exposure to light so that the patterned photoresist layer is formed on the areas unexposed to ultraviolet light where the composition is left undissolved. A negative-working photoresist composition exhibits behavior of a sensitivity and solubility that is the reverse of the positive-working photoresist.

Along with recent progress in the technology of semiconductor devices with a requirement for finer and finer high-fidelity patterning of a line width of 1 micron or even finer to comply with the trend of increased density of integration in semiconductor devices, photolithographic processes of patterning using a positive-working photoresist also envisages a difficult problem. When patterning is desired of an extremely fine contact hole in a fine pattern, alkaline developer solution is admixed with a surface active agent with an object to increase the wettability of the substrate surface with the aqueous developer solution. One of the problems in the addition of a surface active agent to the developer solution is that film residues and scums sometimes occur on the exposed areas where the photoresist layer is to be dissolved away as completely and cleanly as possible. Although the film residues and scums can be removed by gently treating the surface with oxygen plasma or sputtering, no complete solution of the problem can be obtained by such methods because such treatments must be performed under well controlled troublesome conditions and are not efficient in respect of smooth removal of the scums, or give no uniform effect of treatment in finely patterned areas having contact holes of about 1 micron or smaller in diameter. Further, such treatments are costly.

U.S. 4,820,621 to Tanaka et al. has addressed the problem of residue and scum formation by modifying a developer solution with the addition of a non-ionic surface active agent that is a polyoxyethylene alkyl-substituted phenyl ether. The ether is included in the developer solution in an amount of from 50 to 5000 ppm (parts per million). The developer solution is employed in patterning using a positive-working photoresist composition composed of an alkali-soluble novolac resin and a naphthoquinone diazide compound. The '621 patent alleges that patterning the positive photoresist with the developer containing the polyoxyethylene alkyl-substituted phenyl ether prevents formation of residues and scums after development.

Similar residue and scum formation also occur when negative-working photoresists are employed. For example, in manufacturing printed circuit boards UV curable negative-working photoresists may be used. Exposed portions of the photoresist become insoluble in alkaline developer solution and form a protective barrier to other processing chemicals such as etching and plating solutions. Unexposed portions of the photoresist are to rinse freely from the circuit board with an alkaline solution such as a 1% sodium carbonate, monohydrate in water. Development occurs because polymers in the photoresist contain acid functionality. Such acid functionality within the polymers are neutralized in alkaline solution forming a water soluble organic salt. As the dissolved photoresist builds up in solution (developer loading), insoluble organic materials, such as uncured photoresist, begin to form in the developing tank eventually forming a water insoluble residue or scum. Presence of anti-foam additives (conventionally added to developing solutions to minimize foaming) greatly increases the tendency for residue and scum to form. As the level of scum builds, chances increase for an inadvertent redeposit of these water insoluble residues onto the developed circuit board. Such redeposited residues cause a retardation of the etching solution (etching chemistries have difficulty penetrating any organic residues). Where etch is retarded, circuit shorts form causing a defective circuit board. In addition to increasing the potential for defective circuit boards, the residue also makes cleaning equipment difficult, thus increasing maintenance time. Such residue and scum can adhere to developer apparatus surfaces, plug nozzles, and redeposit onto surfaces of printed wiring boards causing defects in the boards.

In addition to the problem of built-up residue and scum formation from primary photoresists, there also is a residue and scum build-up problem from secondary photoresists. Such secondary photoresists may be employed in soldermasks. Residue and scum are deposited on a substrate as a result of component separation in the soldermask. Such component separation may be exacerbated when an improperly balanced soldermask developer solution, i.e., improper developing conditions and/or soldermask developer solution chemistry, contact the soldermask. Built-up residue and scum from secondary photoresists often appear as a bright green coating on a substrate such as a developer apparatus.

Cleaners used to remove, i.e., clean, residue and scum may vary in composition. Cleaners include as active ingredients a strong base such as sodium hydroxide, and chelating agents such as ethylene diamine tetraacetate (EDTA). Surfactants, solvents and emulsifying agents may also be included in cleaners. Cleaners are employed at temperature ranges from about 45° C to about 55° C. However, workers in the field using cleaners have discovered that the residue problem is often made worse. Often the equipment has to be manually cleaned to remove the residue from the photoresist as well as from the cleaners. Such manual cleaning is both a labor and time intensive operation that can cause a significant loss of production time. Further, as mentioned above, such cleaners are not effective enough for removing residue from new generation photoresists that have many hydrophobic aromatic materials. Such hydrophobic materials are especially difficult to re-emulsify, i.e., clean, with cleaners. Accordingly, a composition that reduces or prevents residue and scum formation is highly desireable.

U.S. 5,922,522 to Barr et al.; U.S. 6,063,550 to Lundy et al.; and U.S. 6,248,506 B1 to Lundy et al. disclose surfactant and surfactant mixtures included in developer solutions that prevent or reduce the formation of residues and scum on circuit boards and circuit board manufacturing equipment. Such surfactants are composed of a hydrophobic group, an alkoxylated hydrophilic group and a nonionic or anionic capping group. Examples of suitable hydrophobic groups include nonylphenol, octylphenol and tristyrylphenol. Examples of suitable alkoxylated hydrophilic groups include ethylene oxide, propylene oxide and ethylene oxide/propylene oxide groups. Examples of suitable capping groups include hydroxyl, carboxyl, sulfonyl, phosphonyl, or mixtures thereof. Such residue and scum reducing compounds are included in developer solutions in amounts of from about 0.05% to about 1.0% by weight.

Developer solutions may be aqueous alkaline solutions such as solutions of sodium carbonate. Other bases such as sodium hydroxide, potassium hydroxide, triethanolamine, potassium carbonate, sodium bicarbonate, and potassium bicarbonate are also employed to provide the alkalinity for developer solutions. Prior to use, such developer solutions are diluted from their more concentrated forms. Dilution ratios may vary. Typically, sodium carbonate is applied as a 1.0% by weight solution. The alkalinity of the developing solution forms salts with acid functionalities of binder polymers of photoresists, such as carboxylic acid functionality, rendering the binders miscible in the aqueous alkaline solution. Photoresists are applied as a layer to a substrate, exposed to patterned actinic radiation, and developed in aqueous alkaline solutions which washes away non-exposed, un-polymerized portions of the photoresist layer when the photoresist is a negative-working photoresist. If the photoresist is positive-working, the exposed portions of the photoresist are washed away.

Although the developer solutions disclosed in U.S. 5,922,522; U.S. 6,063,550; and U.S. 6,248,506 B1 provide an effective means of reducing the amount of build-up of residue and scum on substrates containing photoresist, such as circuit boards, and equipment used in the manufacture of electronic components, workers are required to make secondary additions to developer solutions when preparing them from their more concentrated forms for developing photoresist. Such precipitates are ineffective in reducing or preventing residue and scum formation and may contribute to residue formation. Re-solublizing the precipitate may be difficult, thus the precipitate is filtered from the solution. Secondary additions of the precipitated material are made to compensate for a loss of residue reducing compounds, thus increasing the cost of developer preparation. Such problems are due to incompatibilities between two or more components of the composition. Accordingly, there is a need for a developer concentrate that remains stable during storage.

Regardless of the efforts to prevent build-up of residue and scum in developer apparatus such as a conventional spin developer, or a spray developer where developer solution is sprayed onto a substrate surface, repeated use of such apparatus inevitably results in the build-up of residue and scum. At a certain point the residues and scum accumulate to such an extent that the equipment is shut down for cleaning, thus reducing product output. Such residue and scum include hydrophobic aromatic materials such as photoinitiators, dyes, (meth)acrylic monomers and other organic materials that make up photoresists as well as antifoam agents and surfactants. Such residue and scum are often difficult to re-emulsify or clean with developer apparatus cleaners.

Accordingly, there is a need for a composition that reduces or prevents residue and scum formation as well as being a storage stable concentrate and makes cleaners more effective.

### Summary of the Invention

The present invention is directed to a stable concentrate composed of an alkaline component in combination with a compound that reduces or prevents residue formation on a substrate or in a solution.

Advantageously, the concentrate of the present invention is stable during storage such that secondary additions of components do not have to be added to the composition to restore components that have precipitated out of solution, or to try and resolubilize the components. Another advantage of the stable concentrate is that it may be employed to reduce or prevent residue formation on a substrate deposited by photolithographic compositions such as organic residues and scum from both positive-working and negative-working photoresist. Such substrates include, but are not limited to, developer apparatus used in applying developer solution to a photoresist as well as other apparatus used in the manufacture of printed wiring boards. Examples of developer apparatus include, but are not limited to, spray developers where developer is sprayed onto a photoresist, or conventional spin developers, immersion developers, or a batch or feed-and-bleed operation apparatus, and the like. The stable concentrate of the present invention also may be employed to reduce or prevent residue and scum from forming in solutions.

Continuous or prolonged use of equipment employed in applying photoresist or that contacts photoresist during the manufacture of photolithographic devices such as printed wiring boards results in the build-up of undesirable residue on the equipment. The built-up residue may block or clog lines or movable parts on the equipment resulting in production shutdown. Additionally, the residue build-up on printed wiring boards causes defects in the boards such as electrical shorts. Cleaning is not always effective because residue and scum contain chemicals that are difficult to re-emulsify, i.e., clean, with many cleaners. Also, cleaners may further contaminate the equipment and manufactured articles. The composition of the present invention eliminates or at least reduces the difficulty of cleaning built-up residue and scum from a substrate or from residue and scum forming in a solution.

In addition to being a storage stable concentrate for reducing residue and scum formation, the compositions of the present invention are developers which develop photoresist. Accordingly, the present invention also is directed to a developer and a method of developing photoresist

A primary objective of the present invention is to provide for a storage stable concentrate.

Another objective of the present invention is to provide for a stable concentrate that may be employed to reduce or prevent the formation of residue and scum originating from photolithographic compositions.

A further objective of the present invention is to provide for a stable concentrate that may be employed to reduce or prevent residue and scum formation caused by positive-working and negative working photoresist.

An additional objective of the present invention is to provide for an improved developer solution.

Still yet, another objective of the present invention is to provide for an improved method of developing photoresist.

Other advantages may be ascertained by a person of skill in the art reading the following description of the invention and the appended claims.

### Detailed Description of the Invention

A stable composition of the present invention is a concentrate composed of an alkaline component in combination with a compound that reduces or prevents formation of residue and scum on a substrate or in a solution. The alkaline component that develops photoresist is at concentrated levels in the composition and the compound that reduces or prevents formation of residue and scum is employed in sufficient amounts to perform the inhibiting function. Advantageously, the concentrate of the present invention is suitable for a developer solution to develop both positive-working and negative-working photoresists, and at the same time reduces residue and scum formation from photolithographic compositions. Photolithographic compositions within the scope of the present invention include chemical compositions that are employed in photolithographic processes such as in the manufacturing of printed wiring boards. Such photolithographic compositions include, but are not limited to, photoresists, cleaning compositions for photolithographic apparatus and developer solutions and the like. While photoresists are a source of residue and scum build-up, many surfactants and antifoam agents employed in other solutions such as developer solutions and cleaning solutions also add to the build-up of residue and scum.

The concentrates of the present invention are storage stable. A storage stable concentrate within the scope of the present invention means that the concentrate or solution does not require secondary additions. Unstable concentrates have the problem that components separate or precipitate out of solution during storage such that the components have to be re-solubilized or filtered from solution and new components have to be added in sufficient amounts for the composition to perform its desired function.

Bases, such as sodium carbonate, sodium bicarbonate, potassium bicarbonate, sodium metasilicate, NaOH, KOH, triethanolamine, potassium carbonate and the like may be used as the alkaline component to provide the alkalinity necessary for developing photoresists. The alkaline component composes from about 15% by weight to about 80% by weight of the composition as a concentrate. More preferably, the alkaline component composes from about 30% by weight to about 50% by weight of the composition as a concentrate. After appropriate dilution of the concentrate, the solution may be employed to develop a photoresist. The alkalinity of the developing solution forms salts with the acid functionality of a binder polymer, typically carboxylic acid functionality, rendering the binder polymer miscible in the alkaline aqueous solution. Thus, photoresists are applied as a layer to a substrate, exposed to patterned actinic radiation, and developed in alkaline solutions which wash away portions of the photoresist layer.

The component that reduces or prevents residue and scum formation may be any suitable chemical compound or combination of chemical compounds that reduce or prevent scum formation on a substrate or in a solution and are stable in the concentrates, in particular alkaline concentrates. Examples of such compounds include, but are not limited to, aromatic sulfur containing compounds such as aromatic sulfonic acids and their salts, such as sulfonates, and sugars and sugar derivatives. Illustrative of aromatic sulfur compounds within the scope of the present invention have a formula: 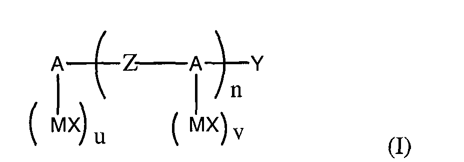 where n is an integer of 0 to 20, preferably n is an integer of from 1 to 10, more preferably n is an integer of from 1 to 3 and most preferably n is 1. A is phenyl, unsubstituted or substituted, or naphthalenyl unsubstituted or substituted. Substituent groups include, but are not limited to, amine, halogen, hydroxyl or alkyl. Y is hydrogen, halogen, aliphatic, aromatic, alicyclic, hydroxyl, preferably hydrogen or aliphatic and most preferably hydrogen. Subscripts u and v are 0 to 4. When u or v is 0, a hydrogen takes the place of MX. Z is oxygen, nitrogen, sulfur, sulfonyl, sulfonate, -CO-, -(CH₂)ₘ-where m is an integer of from 1 to 5, preferably m is equal to 1, or Z is a direct bond. M is -COO⁻, -SO₃⁻, -SO₄²⁻, PO₄³⁻, -PO₄(R')₂ where R' is a hydrocarbon, preferably a (C₁-C₅) alkyl. Compounds of formula I have at least one sulfur atom in their structure. Variable X is a counter cation such as H⁺ or other suitable cation. Illustrative of other suitable cations include, but are not limited to, alkali metal cations, such as lithium, sodium, and potassium, alkaline earth metals such as magnesium and calcium, transition metal cations, such as chromium, iron, manganese, cobalt, nickel, vanadium, titanium, ruthenium, platinum and the like, zinc, ammonium (NH₄⁺), other protonated amines, such as protonated ethylene diamine, choline, and the like.
A preferred aromatic sulfur compound has a formula: 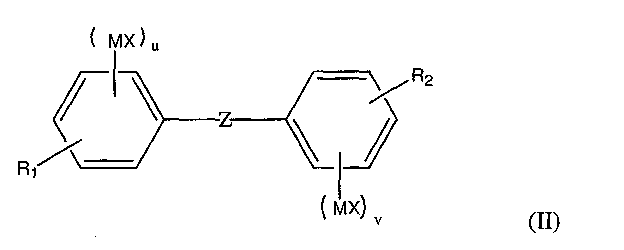 where Z, M, and X are defined as above with the proviso that there is at least one sulfur atom on the formula, u and v are integers of from 0 to 1, and R₁ and R₂ are independently hydrogen, an aliphatic unsubstituted or substituted, cycloaliphatic unsubstituted or substituted, aromatic unsubstituted or substituted, halogen or hydroxyl. Substitutent groups include, but are not limited to, halogen and hydroxyl. Y of formula I above is hydrogen and n = 1.

Examples of suitable aliphatic groups include, but are not limited to, linear or branched alky groups of from 1 to 25 carbon atoms, preferably from 5 to 12 carbon atoms. Illustrative aliphatic groups are methyl, ethyl, propyl, isopropyl, butyl, isobutyl, pentadecyl, hexadecyl, octadecyl, dodecyl and the like. Examples of suitable cycloaliphatic groups include, but are not limited to, cycloaliphatic groups having from 5 to 10 carbon atoms, preferably from 5 to 6 carbon atoms. Examples of hydrophobic aromatic groups include, but are not limited to, aromatic groups having from 5 to 14 carbons, preferably from 5 to 6 carbons.

Counter ion X includes, but is not limited to, sodium, potassium, calcium, magnesium, ammonium or an amine. Ammonium ion radicals are of the formula (R")₃NH⁺ wherein each R" is independently hydrogen, a C₁-C₄ alkyl or a C₁-C₄ hydroxyalkyl radical. Illustrative C₁-C₄ alkyl and hydroxyalkyl radicals include methyl, ethyl, propyl, isopropyl, butyl, hydroxymethyl and hydroxyethyl. Typical ammonium ion radicals include ammonium (N⁺H₄), methylammonium (CH₃N⁺H₃), ethylammonium (C₂H₅N⁺H₃), dimethylammonium ((CH₃)₂NH₂⁺), methylethylammonium (CH₃N⁺H₂C₂H₅), trimethylammonium ((CH₃)₃N⁺H₂), dimethylbutylammonium ((CH₃)₂N⁺HC₄H₉), hydroxyethylammonium (HOCH₂CH₂N⁺H₃) and methylhydroxyethylammonium (CH₃N⁺H₂ CH₂CH₂OH). Preferably, X is hydrogen, sodium, calcium, potassium or ammonium.

Preferably, M is -SO₃⁻, and R₁ and R₂ are the same or different and are hydrogen or a 1 to 20 carbon aliphatic group, or a 5 to 6 hydrophobic aromatic group with the proviso that when one of R₁ or R₂ is hydrogen the other is an aliphatic or aromatic group.

Compounds of formula II above include diphenyl oxides which may be prepared by any suitable method know in the art. Alkylated diphenyl oxides may be sulfonated with any suitable sulfonating agent, such as sulfur trioxide, mixtures of sulfur dioxide and sulfur trioxide, chlorosulfonic acid, and the like by conventional procedures. The resulting sulfonic acid can be neutralized with an alkali metal hydroxide or carbonate, such as sodium carbonate or potassium hydroxide, or by the use of any other suitable base conventionally employed in the preparation of ammonium or alkali metal salts or aryl sulfonic acids. Methods for preparing diphenyl oxide compounds are disclosed in U.S. 3,248,335 and U.S. 4,687,593 the entire disclosures of which are hereby incorporated herein by reference. The disclosures of both patents provide sufficient information to a person of skill in the art to make any of the diphenyl oxide compounds of the present invention.

Diphenyl oxides within the scope of the present invention also may be obtained commercially. Commercially available solutions containing alkylated diphenyl oxide sulfonate surfactants are DOWFAX® C10L, DOWFAX® 8390 and DOWFAX® 8390A. ("DOWFAX® is a registered trademark of The Dow chemical Company for its brand of these anionic surfactants.) The alkyl group R₁ and R₂ is predominantly a hexadecyl (C₁₆) group in the 8390 and 8390A composition. DOWFAX® 8390A contains about 25% of the acid form of the surfactant, that is, in which X is hydrogen. DOWFAX® 8390 contains about 35% of sodium salts of the surfactant, that is, in which X is sodium. DOWFAX® 8390A solution is fully or partially neutralized with ammonium hydroxide.

In addition to the diphenyl sulfur compounds described above, other suitable aromatic sulfur compounds may include linear alkyl benzene sulfonic acids and salts thereof having the following formula: 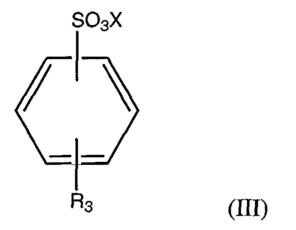 where X is as defined above, n is 0, and Y is hydrogen in formula I above, and R₃ is a saturated or unsaturated aliphatic hydrocarbon group of from 5 to 20 carbons. Preferably R₃ is 10 to 12 carbons.

Another suitable aryl sulfonic acid or salt thereof within the scope of the present invention is an alkylnaphthalene sulfonate having the formula: 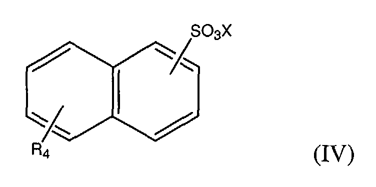 where X is as defined above, Y is hydrogen, and n is 0 in formula I above, and R₄ is saturated or unsaturated aliphatic hydrocarbon having from 8-18 carbon atoms, preferably from 10 to 16 carbon atoms.

Any suitable sugar or sugar derivative that reduces or prevents residue and scum formation and which is stable in an alkaline concentrate may be employed to practice the present invention. Such sugars and sugar derivatives include glycosides, polyglycosides and ethers thereof.

Various glycoside and polyglycoside compounds including alkoxylated glycosides may be used. A useful polyglycoside is one according to the formula:

RO―(C_{*p*}H₂_{*p*}O)_{*r*}―(W)_{*x*} (V)

where W is derived from glucose, R is a hydrophobic group selected from alkyl groups, alkylphenyl groups, hydroxyalkylphenyl groups as well as mixtures thereof, wherein the alkyl groups may be straight chained or branched, which contain from 8 to 18 carbon atoms, p is 2 or 3, r is an integer from 0 to 10, and x is a value from 1 to 8.

A further group of alkyl glycosides suitable for use in the practice of this invention may be represented by formula VI below:

R₄O―(R₃O)_{*y*}―(G)_{*x*}W_{*b*} (VI)

wherein: R₄ is a monovalent organic radical containing from 6 to 30, preferably from 8 to 18 carbon atoms; R₃ is a divalent hydrocarbon radical containing from 2 to 4 carbon atoms; O is an oxygen atom; y is an integer from 0 to 1; G is a moiety derived from a reducing saccharide containing 5 or 6 carbon atoms; and x is an integer from 1 to 5; W is O₂ M¹, 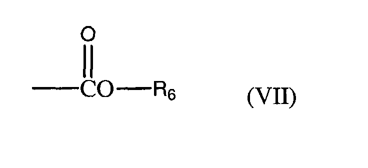 O(CH₂), CO₂M¹, OSO₃M¹, or O(CH₂)SO₃M¹; R₆ is (CH₂)CO₂M¹ or CH==CHCO₂M¹; (with the proviso that Z can be O₂M¹ only if W is in place of a primary hydroxyl group in which the primary hydroxyl-bearing carbon atom, ―CH₂OH, is oxidized to form a 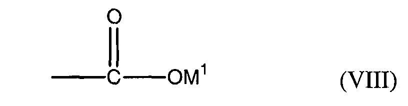 group); b is a number of from 0 to 3k +1 preferably an average of from 0.5 to 2 per glycosal group; k is 1 to 10, M¹ is H⁺ or an organic or inorganic counterion, particularly cations such as, for example, an alkali metal cation, ammonium cation, monoethanolamine cation, or calcium cation.

Examples of such alkylglycosides as described above include, but are not limited to, APG™ 325 CS Glycoside® which is described as being a 50% C₉-C₁₁ alkyl polyglycoside, also commonly referred to as D-glucopyranoside, (commercially available from Henkel Corp, Ambler Pa.) and Glucopon™ 625 CS which is described as being a 50% C₁₀-C₁₆ alkyl polyglycoside, also commonly referred to as a D-glucopyranoside, (available from Henkel Corp., Ambler Pa.).

Exemplary alkyl glycosides suitable for use in the practice of this invention include those which may be represented by the formula: 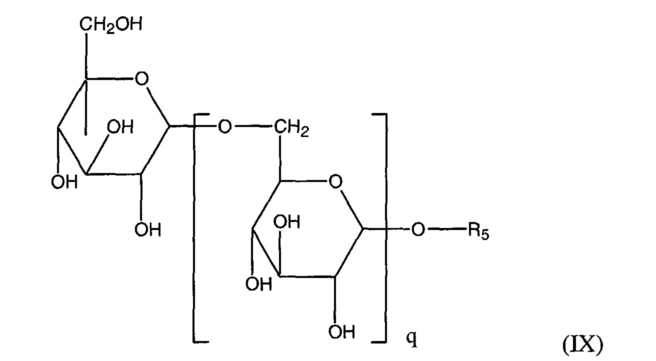 where R₅ is an alkyl group, preferably a linear alkyl chain, such as C₈ to C₁₆ alkyl groups; q is an integer of from 0-3, inclusive.

Examples of such alkylpolyglycoside compounds according to structure IX include: where R₅ is composed of C₈ and C₁₀ alkyl chains yielding an average value of about 9.1 alkyl carbons per molecule (Glucopon® 220 UP, Glucopon® 225 DK); where R₅ is composed of C₈, C₁₀, C₁₂, C₁₄ and C₁₆ alkyl chains yielding an average value of about 10.3 alkyl carbons per molecule (Glucopon® 425); where R₅ is composed of C₁₂, C₁₄ and C₁₆ alkyl chains yielding an average value of about 12.8 alkyl carbons per molecule (Glucopon® 600 UP, Glucopon® 625 CSUP, and Glucopon® 625 FE, all of which are available from Henkel Corp., Ambler Pa.). Also useful as the alkylpolyglycoside compound is Triton® CG-110 (Union Carbide Corp.). Another useful alkylglycoside is GLUCOPON® 325N which is described as being a C₉-C₁₁ alkyl polyglycoside, also commonly referred to as D-glucopyranoside (from Henkel Corp, Ambler Pa.).

Other suitable alkyl polyglycosides that are commercially available include, but are not limited to, as GLUCOPON®, or PLANTAREN® from Henkel Corporation, Ambler, PA., 19002. Examples of such alkyl polyglycosides include but are not limited to:
1. GLUCOPON® 225 Surfactant--an alkyl polyglycoside in which the alkyl group contains 8 to 10 carbon atoms and having an average degree of polymerization of 1.7.
2. GLUCOPON® 425 Surfactant--an alkyl polyglycoside in which the alkyl group contains 8 to 16 carbon atoms and having an average degree of polymerization of 1.6.
3. GLUCOPON® 625 Surfactant--an alkyl polyglycoside in which the alkyl groups contains 12 to 16 carbon atoms and having an average degree of polymerization of 1.6.
4. APG® 325 Surfactant--an alkyl polyglycoside in which the alkyl groups contains 9 to 11 carbon atoms and having an average degree of polymerization of 1.6.
5. GLUCOPON® 600 Surfactant--an alkyl polyglycoside in which the alkyl groups contains 12 to 16 carbon atoms and having an average degree of polymerization of 1.4.
6. PLANTAREN® 2000 Surfactant--a C₈₋₁₆ alkyl polyglycoside in which the alkyl group contains 8 to 16 carbon atoms and having an average degree of polymerization of 1.4.
7. PLANTAREN® 1300 Surfactant―a C₁₂₋₁₆ alkyl polyglycoside in which the alkyl groups contains 12 to 16 carbon atoms and having an average degree of polymerization of 1.6.

Compounds that reduce or prevent residue and scum formation are included in the stable compositions of the present invention in amounts of from about 15% by weight to about 60% by weight of the composition as a concentrate, preferably from about 20% by weight to about 40% by weight of the concentrate.

In addition to the compounds described above, the stable concentrates optionally may contain auxiliary surfactants, antifoam agents, chelating agents and a solvent provided such additions do not destabilize the composition. Suitable solvents include water or any organic solvent where the components of the composition remain soluble in solution. Solvents may be added to bring the concentrate to 100% by weight. Concentrates of the present invention consist essentially of an alkaline component, an aromatic sulfur compound, a sugar or derivative thereof, an antifoam agent and a solvent. Preferably, stable concentrates of the present invention consist of an alkaline component, an aromatic sulfonic acid or salt thereof, a sugar or sugar derivative and a solvent. A concentrate within the scope of the present invention refers to a solution where its components are at higher concentrations than where workers in the art employ the composition to develop a photoresist.

Surprisingly, the stable compositions of the present invention reduce or prevent organic residue and organic scum from both positive-working (both liquid and dry film) and negative-working photoresist (both liquid and dry film). Such organic residue and organic scum on a substrate or in a solution are difficult to remove with many cleaners and surfactants because of the types of chemicals used in photoresists, in particular the new generation of photoresists which contain many compounds of a hydrophobic aromatic character.

Additionally, the compositions of the present invention also reduce or prevent formation of residues and scum deposited by secondary photoresists. Such photoresist may be employed in soldermasks. Residue and scum are deposited on a substrate as a result of component separation in the soldermask. Such component separation may be exacerbated when an improperly balanced soldermask developer solution, i.e. improper developing conditions and/or soldermask developer solution chemistry, contact the soldermask. Residue and scum build-up on substrates as printed wiring boards and soldermask developer apparatus. Built-up residue and scum may appear as a bright green coating on developer apparatus surfaces. The bright green coating comes from an oily layer of water insoluble material from the secondary photoresist in which pigment from the photoresist concentrates. Generally, there is a higher level of hydrophobic aromatic compounds in secondary photoresist formulations than primary photoresist formulations. Thus reducing or preventing residue and scum deposited by secondary photoresists is a further improvement of the compositions of the present invention.

Residues and scum from photoresist include, but are not limited to, such chemical materials as hydrophobic aromatic materials such as photoinitiators, thermoinitiators, dyes, acrylic, and methacrylic monomers. Photoinitiators such as photoacid generators, photobase generators or free-radical generators once built-up as residue or scum on a substrate are more difficult to remove than many of the other components that compose the residue and scum. Such materials do not readily re-emulsify once they build-up on a substrate such as photolithographic manufacturing apparatus. Such materials are typically hydrophobic aromatic compound.

Photoresists vary in composition. Generally, a photoresist composition may compose from about 20% to about 90% by weight of a binder polymer, about 15% to about 50% by weight of α,β-ethylenically unsaturated compounds (cross-linkers) such as monomers and short-chain oligomers and from about 0.1% to about 25% by weight of a photoinitiator or photoinitiator chemical system, preferably from about 5% to about 15% by weight. Liquid photoresists may contain a larger concentration of monomers or short-chain oligomers in relation to polymer binders whereas dry film may contain larger concentrations of polymer binders. Such concentrations are known in the art. Other components employed in a photoresist that may contribute to residue and scum build-up are discussed below. Built-up residue and scum from liquid photoresist appears as crystalline material on a substrate.

Examples of components that compose a photoresist that may cause undesirable built-up residue or scum on a substrate include, but are not limited to, polymeric binders such as those containing as polymerized units one or more ethylenically or acetylenically unsaturated monomers. Examples of monomers include, but are not limited to: (meth)acrylic acid, (meth)acrylamides, alkyl (meth)acrylates, alkenyl (meth)acrylates, aromatic (meth)acrylates, vinyl aromatic monomers, nitrogen-containing compounds and their thio-analogs, substituted ethylene monomers, cyclic olefins, substituted cyclic olefins, and the like. Preferred monomers include (meth)acrylic acid, alkyl (meth)acrylates and vinyl aromatic monomers. Such polymeric binders may be homopolymers or copolymers and preferably copolymers.

Cross-linkers that may cause residue or scum build-up include di-, tri-, tetra-, or higher multi-functional ethylenically unsaturated monomers. Examples of such cross-linkers include, but are not limited to: trivinylbenzene, divinyltoluene, divinylpyridine, divinylnaphthalene and divinylxylene; and such as ethyleneglycol diacrylate, trimethylolpropane triacrylate ("TMPTA"), diethyleneglycol divinyl ether, trivinylcyclohexane, allyl methacrylate ("ALMA"), ethyleneglycol dimethacrylate ("EGDMA"), diethyleneglycol dimethacrylate ("DEGDMA"), propyleneglycol dimethacrylate, propyleneglycol diacrylate, trimethylolpropane trimethacrylate ("TMPTMA"), divinyl benzene ("DVB"), glycidyl methacrylate, 2,2-dimethylpropane 1,3 diacrylate, 1,3-butylene glycol diacrylate, 1,3-butylene glycol dimethacrylate, 1,4-butanediol diacrylate, diethylene glycol diacrylate, diethylene glycol dimethacrylate, 1,6-hexanediol diacrylate, 1,6-hexanediol dimethacrylate, tripropylene glycol diacrylate, triethylene glycol dimethacrylate, tetraethylene glycol diacrylate, polyethylene glycol 200 diacrylate, tetraethylene glycol dimethacrylate, polyethylene glycol dimethacrylate, ethoxylated bisphenol A diacrylate, ethoxylated bisphenol A dimethacrylate, polyethylene glycol 600 dimethacrylate, poly(butanediol) diacrylate, pentaerythritol triacrylate, trimethylolpropane triethoxy triacrylate, glyceryl propoxy triacrylate, pentaerythritol tetraacrylate, pentaerythritol tetramethacrylate, dipentaerythritol monohydroxypentaacrylate, ethoxylated diacrylates, ethoxylated triacrylates such as ethoxylated TMPTA and ethoxylated TMPTMA, ethoxylated tetraacrylates, divinyl silane, trivinyl silane, dimethyl divinyl silane, divinyl methyl silane, methyl trivinyl silane, diphenyl divinyl silane, divinyl phenyl silane, trivinyl phenyl silane, divinyl methyl phenyl silane, tetravinyl silane, dimethyl vinyl disiloxane, poly(methyl vinyl siloxane), poly(vinyl hydro siloxane), poly (phenyl vinyl siloxane), glycosyl ureas including di-, tri- and tetra-glycosyl ureas, epoxies and mixtures thereof. Such cross-linking agents are generally commercially available.

Photoimageable compositions contain one or more photoactive components. The photoactive components may be photoacid generators, photobase generators or free-radical generators. Such photoactive components are a major source of residue and scum formation.

Example of photoacid generators include halogenated triazines, onium salts, sulfonated esters, halogenated sulfonyloxy dicarboximides, diazodisulfones, α-cyanooxyaminesulfonates, imidesulfonates, ketodiazosulfones, sulfonyldiazoesters, 1,2-di(arylsulfonyl)hydrazines and the like.

Free-radical generators include, but are not limited to, n-phenylglycine, aromatic ketones such as benzophenone, N, N'-tetramethyl-4, 4'-diaminobenzophenone [Michler's ketone], N,N'-tetraethyl-4,4'-diaminobenzophenone, 4-methoxy-4'-dimethylaminobenzophenone, 3,3'-dimethyl-4-methoxybenzophenone, p,p'-bis(dimethylamino)benzophenone, p,p'-bis(diethylamino)-benzophenone, anthraquinone, 2-ethylanthraquinone, naphthaquinone and phenanthraquinone, benzoins such as benzoin, benzoinmethylether, benzoinethylether, benzoinisopropylether, benzoin-n-butylether, benzoin-phenylether, methylbenzoin and ethybenzoin, benzyl derivatives such as dibenzyl, benzyldiphenyldisulfide and benzyldimethylketal, acridine derivatives such as 9-phenylacridine and 1,7-bis(9-acridinyl)heptane, thioxanthones such as 2-chlorothioxanthone, 2-methylthioxanthone, 2,4-diethylthioxanthone, 2,4-dimethylthioxanthone and 2-isopropylthioxanthone, acetophenones such as 1,1-dichloroacetophenone, p-t-butyldichloro-acetophenone, 2,2-diethoxyacetophenone, 2,2-dimethoxy-2-phenylacetophenone, and 2,2-dichloro-4-phenoxyacetophenone, 2,4,5-triarylimidazole dimers such as 2-(o-chlorophenyl)-4,5-diphenylimidazole dimer, 2-(o-chlorophenyl)-4,5-di(m-methoxyphenyl imidazole dimer, 2-(o-fluorophenyl)-4,5-diphenylimidazole dimer, 2-(o-methoxyphenyl)-4,5-diphenylimidazole dimer, 2-(p-methoxyphenyl)-4,5-diphenylimidazole dimer, 2,4-di(p-methoxyphenyl)-5-phenylimidazole dimer, 2-(2,4-dimethoxyphenyl)-4,5-diphenylimidazole dimer and 2-(p-methylmercaptophenyl)-4,5-diphenylimidazole dimer, and the like. Though, not a free-radical generator, triphenylphosphine may be included in the photoactive chemical system as a catalyst.

Optional additives that may be used in photoimageable compositions and that cause residue and scum include, but are not limited to: anti-striation agents, plasticizers, speed enhancers, fillers, dyes, film forming agents, non-polymerizable organic acids and the like. Suitable plasticizers include esters such as dibenzoate esters. Non-polymerizable organic acids may also be added to photoresist compositions. Such organic acids are substantially non-polymerizable with the polymeric binders, optional cross-linking agents or both. A wide variety of organic acids may suitably be added to photoresist compositions. Suitable organic acids include, but are not limited to, alkanecarboxylic acids and arylcarboxylic acids, sulfonic acids such as alkanesulfonic acids and arylsulfonic acids, phosphonic acids such as alkylphosphonic acids and arylphosphonic acids, and the like. Exemplary carboxylic acids include, but are not limited to, (C₁-C₁₂)alkylcarboxylic acids, (C₁-C₁₂)alkyldicarboxylic acids, (C₁-C₁₂)alkyltricarboxylic acids, substituted (C₁-C₁₂)alkylcarboxylic acids, substituted (C₁-C₁₂)alkyldicarboxylic acids, substituted (C₁-C₁₂)alkyltricarboxylic acids, amine carboxylic acids such as ethylenediamine tetraacetic acid, arylcarboxylic acids such as arylmonocarboxylic acids, aryldicarboxylic acids and aryltricarboxylic acids, and substituted arylcarboxylic acids. Preferred organic acids include formic acid, acetic acid, propionic acid, oxalic acid, malonic acid, succinic acid, glutaric acid, adipic acid, glycolic acid, lactic acid, tartaric acid, citric acid or malic acid, ethylenediamine tetraacetic acid, phthalic acid, benzene tricarboxylic acid, salicilic acid, cyclohexanecarboxylic acid, 1,4-cyclohexanedicarboxylic acid and sebacic acid.

A wide variety of photoresist strip enhancers also may be used in photoresists. Such strip enhancers may contribute to residue and scum build-up. Examples of photoresist strip enhancers are compounds containing one or more trihalomethyl-substituents in an alpha position relative to a group capable of stabilizing a negative charge.

The stable compositions of the present invention may be employed in any suitable method for developing a photoresist. Stable compositions of the present invention are prepared as concentrates. Prior to use, especially as a developer solution, the concentrates are diluted to suitable developer ranges. The alkaline component in the diluted composition may range from 0.1% by weight to about 14% by weight of the composition, preferably from about 1% by weight to about 10% by weight. Compounds that reduce or prevent residue and scum formation range from about 0.01% by weight to about 14% by weight of the developer solution when employed in developing photoresists. Preferably, the compounds that reduce or prevent residue and scum formation range from about 0.5% by weight to about 10% by weight of the developer solution, more preferably from about 1% by weight to about 5% by weight.

Using a method for forming a printed circuit board for purposes of exemplification, a photoimageable composition may be applied to a substrate having a pattern of conductive material disposed thereon. The substrate may be a copper laminate substrate or other metal substrate. Other suitable substrates include those prepared by laminating multilayer boards for the manufacture of printed circuit boards with vias (through-holes) and interconnections which may contain solder.

A photoresist is coated onto the copper laminate substrate using conventional techniques. The coating is deposited to yield a dry film thickness of at least about 0.50 mil. After coating, the wet film formed is dried at a suitable temperature to remove solvent.

A process of transferring an image to the photoresist coating involves exposing the coating to a source of patterned activating radiation to initiate the photoreaction in exposed areas. Suitable sources of activating radiation include actinic radiation, x-rays, etc. Following exposure, the layer is subjected to a low temperature bake to initiate crosslinking of the exposed portions of the binder by the liberation of the photogenerated catalyst. The bake conditions comprise heating to a temperature capable of initiating the curing reaction but the temperature should be below that temperature where thermal crosslinking would occur in unexposed areas of the film.

Areas not exposed to activating radiation are readily dissolved by aqueous alkali solutions such as sodium hydroxide, sodium metasilicate, sodium carbonate, potassium hydroxide, potassium carbonate, ethylene diamine and the like if the photoresist is negative-working. Positive-working photoresists work opposite to that of negative-working. Concentrates of the present invention are diluted with a solvent prior to applying them to develop a photoresist. Concentrates are diluted to concentrations of from about 0.1% by weight to about 14% by weight of the alkaline component in the developer solution. Developer solutions range in pH of from about 8.0 to about 14.0, preferably from about 10.0 to about 12.0 during development. The developer solution is applied to the photoresist by any suitable method known in the art. A typical development time is about 30 to about 60 seconds. After development of the image, the remainder of the photoresist is characterized by a partial cure whereby most of the binder components are crosslinked. A second cure may be desirable to achieve full thermal and electrical solder mask properties. Other examples of methods which the developer of the present invention may be used include methods disclosed in U.S. 5,312,715; U.S. 5,397,685; U.S. 5,334,488; U.S. 5,017,742; U.S. 5,007,990; and U.S. 4,544,619, the disclosures of which are hereby incorporated herein in their entireties by reference.

While the compositions of the present invention reduce and prevent residue and scum formation, cleaning apparatus on a weekly, biweekly or monthly regular schedule may also help further reduce residue and scum formation. Cleaners known in the art may be employed to clean photolithographic apparatus. Cleaning within the scope of the present invention means removing or re-emulsifying built-up residue and scum as opposed to reducing or preventing residue and scum formation.

Advantageously, the residue and scum reducing concentrates and developers of the present invention provide for a means of reducing or preventing the formation of residue and scum deposited by photolithographic compositions on substrates or in solutions. In addition, the developer composition also enables residue or scum that does form to be readily re-emulsified. Cleaning any residue and scum which may form on substrates such as printed wiring boards or developer apparatus is made easier because the residue and scum is easier to re-emulsify. The present invention provides for a more efficient manufacturing process since less time is involved in cleaning equipment, and less waste is generated thus providing for a more environmentally friendly cleaning composition and method. Further, the dilute compositions including the concentrates are storage stable, thus secondary additions to the dilute compositions and concentrates are not necessary. Accordingly, the compositions and methods of the present invention are an improvement in the manufacturing of printed wiring boards.

While the present invention is described in the context of reducing or preventing organic residue and scum deposited by photolithographic compositions, the compositions of the present invention may be employed to reduce or prevent formation of organic residue and organic scum on any substrate or in solutions in general.

The following examples are intended to further illustrate the present invention and are not intended to limit the scope of the invention.

### Example 1

### Compatibility of Emulsifiers in Sodium Carbonate Concentrates

Aqueous developer concentrates containing about 30% by weight of sodium carbonate, and about 6% by weight ethylenediamine tetraacetate (EDTA), a chelating agent, were mixed at about 61% by weight with additional water at about 22% by weight and a selected emulsifier at about 17% by weight to screen for compatibility of emulsifiers in a concentrated developer solution. The emulsifiers employed are listed in the tables below. Percentages are in weight/weight unless otherwise stated.

**Table 1**

| Emulsifier | Chemical Type | Observation, Initially | Observation, after standing overnight |
|---|---|---|---|
| Soprophor® BSU | Tristyrylphenol ethoxylate, 16 moles ethylene oxide | Incompatible | Incompatible |
| TWEEN® 80 | Sorbitol ester | Incompatible | Incompatible |
| Tetronic® 90R4 | Ethylenediamine alkoxylate block copolymer | Incompatible | Incompatible |
| Soprophor® FLK | Tristyrylphenol ethoxylate phospate ester, postassium salt | Incompatible | Incompatible |
| Soprophor® 4D384 | Ammonium tristyrylphenol ethoxy (16) sulfate | Incompatible | Incompatible |
| Soprophor® 3D33 | Tristyrylphenol ethoxylate phosphate ester, free acid | Incompatible | Incompatible |
| Dowfax® C6L | Diphenyl ether sulfonate salt | Compatible | Compatible |
| Dowfax® C10L | Diphenyl ether sulfonate salt | Compatible | Compatible |
| Dowfax® 8390 | Diphenyl ether sulfonate salt | 2-phase | Compatible |
| Dowfax® 3B2 | Diphenyl ether sulfonate salt | 2-phase | Compatible |
| Dowfax® 2A1 | Diphenyl ether sulfonate salt | 2-phase | Compatible |
| Glucopon® 220UP | Glucose (decyl, octyl) ether, oligomeric | Compatible | Compatible |
| Glucopan® 225DK | Glucose (decyl, octyl) ether, oligomeric | Compatible | Compatible |
| Glucopon® 425N | Mixed Glucopyranoside (C₁₀ - C₁₆ alkyl), oligomeric, and glucose (decyl, octyl) ether, oligomeric | Compatible | Compatible |
| Glucopon® 625 | Glucopyranoside (C₁₀ - C₁₆ alkyl), oligomeric | Compatible | Gelled |

Incompatible means that the emulsifier did not go into solution or precipitated out of solution. Compatible means that there were no signs of the emulsifier precipitating out of the solution. The compatibility tests showed that the diphenyl ether sulfonate salts, the glucose ether and the glucopyranosides were compatible with a sodium carbonate concentrate. However, some gelling was noticed with Glucopon® 625 emulsifier which indicated some association of one or more components of Glucopon® 625 with the alkali carbonate ions.

To compare emulsifier utility, about 200 ml of aqueous solutions of about 1% (wt/wt) sodium carbonate containing about 23 milsqft/gal of uncured Shipley ProEtch® 1430 dry film photoresist were placed in a modified gas washing bottle. About 8000 ppm (parts per million) of an emulsifier as listed in the table below and an amount of antifoam were added to the solutions. The solutions were aerated with dry air at about 1000 cc/min for about 5 hours and allowed to stand overnight. The solutions were then filtered through a 3 microns filter and the retained sludge was dried and weighed. The controls did not contain an emulsifier.

**Table 2**

| Emulsifier | Dried Sludge Wt (mg) | Antifoam | Antifoam Loading (ppm) |
|---|---|---|---|
| None | 44.5 | naphthenic petroleum hydrocarbon | 250 |
| None | 68.7 | block alkoxy copolymer | 500 |
| Soprophor® BSU | 27.5 | block alkoxy copolymer | 500 |
| Soprophor® Mixture #1 | 7.1 | block alkoxy copolymer | 500 |
| Soprophor® Mixture #2 | 7.8 | block alkoxy copolymer | 500 |
| Soprophor® Mixture #3 | 8.2 | block alkoxy copolymer | 500 |
| Dowfax® 3B2 | 11.9 | naphthenic petroleum hydrocarbon | 250 |
| Dowfax® 8390 | 43.6 | naphthenic petroleum hydrocarbon | 250 |
| Dowfax® 2A1 | 39.8 | naphthenic petroleum hydrocarbon | 250 |
| Dowfax® C10L | 3.0* | naphthenic petroleum hydrocarbon | 250 |
| Dowfax® C6L | 19.7 | naphthenic petroleum hydrocarbon | 250 |
| Glucopon® 220UP | 19.3 | naphthenic petroleum hydrocarbon | 250 |
| Glucopon® 225 | 25.2 | naphthenic petroleum hydrocarbon | 250 |
| Glucopon® 425N | 14.2 | naphthenic petroleum hydrocarbon | 250 |

| | | | |
|---|---|---|---|
| * some loss of sample during aeration Soprophor® Mixture #1 (BSU @ 50%, TWEEN® 80 @ 17%, Tetronic 90R4 @ 33%) Soprophor® Mixture #2 (BSU @ 33%, TWEEN® 80 @ 17%, Tetronic 90R4 @ 50%) Soprophor® Mixture #3 (BSU @ 33%, TWEEN® 80 @ 33%, Tetronic 90R4 @ 33%) | | | |

All emulsifier solutions showed reduction in sludge or residue formations. Most of the residue recovered from the solutions containing the diphenyl ether sulfonates and the glucose ethers and glucopyranosides were believed due to precipitation of solution components because of the incompatibility of the naphthenic petroleum hydrocarbon and the emulsifiers. The results showed that concentrates of the present invention diluted to their developer concentrations reduced residue or sludge formation in contrast to the controls that did not contain any developer solution.

While the Soprophor® and block alkoxy copolymer showed greater sludge reduction than the Dowfax® and Glucopon® compositions, Soprophor®, as shown in Example 1 above, was not compatible in sodium carbonate concentrates.

### Example 2

### Stability of Developer Solutions at Operating Concentrations

A sodium carbonate concentrate is often utilized at about 1 volume of concentrate to about 44 volumes of water to yield about a 1.0% (wt/wt) carbonate solution. To maintain the same volumetric ratio and check a gradient of emulsifier levels, four formulations were calculated, based on specific gravities, to yield a diluted solution containing about 1.0% sodium carbonate and emulsifier at approximately about 4000 ppm, about 6000 ppm, about 8000 ppm or about 10,000 ppm.

**Table 3**

| Target Emulsifier Loading (ppm) | Water (wt %) | Anhydrous Sodium Carbonate (wt %) | Emulsifier (wt %) |
|---|---|---|---|
| 4000 | 54.8 | 31.3 | 13.9 |
| 6000 | 48.3 | 31.0 | 20.7 |
| 8000 | 41.9 | 30.8 | 27.3 |
| 10,000 | 37.0 | 31.2 | 31.8 |

Several emulsifiers were then screened for compatibility at the four concentration levels. Observations were made after mixtures had been allowed to stand for 1 week.

**Table 4**

| Emulsifier | 4000 ppm Mixture | 6000 ppm Mixture | 8000 ppm Mixture | 10,000 ppm Mixture |
|---|---|---|---|---|
| Dowfax® C6L | Clear, compatible | Clear, compatible | Clear, compatible | Clear, compatible |
| Dowfax® C10L | Clear, compatible | Clear, compatible | Clear, compatible | Hazy, slight separation |
| Glucopon® 425N | Clear, compatible | Clear, compatible | Clear, compatible | Clear, compatible |

All of the diluted developer compositions showed long term stability at developer operating concentrations with the exception of Dowfax® C10L at a concentration of 10,000 ppm. The hazy solution and slight phase separation indicated some incompatibility between the emulsifier and the developer solution. Thus, diphenyl ether sulfonate salts as well as a mixture of glucopyranoside and glucose ether were stable in sodium carbonate developer solutions at operating concentrations.

## Claims

1. A stable concentrate composition comprising an alkaline component in combination with a compound that reduces or prevents residue and scum formation on a substrate or in a solution.

2. The composition of claim 1, wherein the alkaline component comprises sodium carbonate, potassium carbonate, sodium hydroxide, potassium hydroxide, sodium metasilicate, triethanolamine, or mixtures thereof.

3. The composition of claim 1, wherein the compound that reduces or prevents residue and scum formation comprises a sugar or a sugar derivative.

4. The composition of claim 3, wherein the sugar or sugar derivative comprises a glycoside, polyglycoside or mixtures thereof.

5. The composition of claim 1, wherein the compound that inhibits or prevents residue and scum formation comprises an aromatic sulfur compound.

6. A stable concentrate composition consisting essentially of an alkaline component in combination with a compound that reduces or prevents residue and scum formation on a substrate or in a solution.

7. The composition of claim 6, wherein the compound that reduces or prevents residue and scum formation comprises an aromatic sulfur compound, a sugar, sugar derivative, or mixtures thereof.

8. A method comprising adding a solvent to a stable concentrate to form a stable dilute solution with components at operating concentrations; and contacting a substrate with the stable dilute solution to reduce or prevent residue and scum formation on the substrate, the stable dilute solution comprises an alkaline component in combination with a compound that reduces or prevents residue and scum formation to inhibit or prevent residue and scum formation on the substrate.

9. The method of claim 8, wherein the compound that reduces or prevents residue and scum formation comprises an aromatic sulfur compound, a sugar, a sugar derivative or mixtures thereof.

10. The method of claim 9, wherein the sugar or sugar derivatives comprise glycosides, polyglycosides or mixtures thereof.
